# EUROPÄISCHE PATENTSCHRIFT

(11) **EP 0 809 306 B1**
(45) Veröffentlichungstag und Bekanntmachung des Hinweises auf die Patenterteilung: **12.12.2001**
(21) Anmeldenummer: 97106866.3
(22) Anmeldetag: 25.04.1997
(51) Int. Cl.: H01L 41/20

(54) **Magnetostriktive Viellagenschicht**
Magnetostrictive multilayer
Multicouches magnétostrictives

(30) Priorität: 24.05.1996 DE 19621166
(43) Veröffentlichungstag der Anmeldung: 26.11.1997
(73) Patentinhaber: Forschungszentrum Karlsruhe GmbH, 76133 Karlsruhe (DE); Centre National de la Recherche Scientifique, Laboratoire de Magnétisme Louis Néel, 38042 Grenoble cedex 9 (FR)
(72) Erfinder: Quandt, Eckhard, Dr., 76356 Weingarten (DE); Ludwig, Alfred, 76307 Karlsbad (DE); Givord, Dominique, 38470 l'Albenc (FR); Mackay, Ken, 38360 Noyarey (FR); Betz, Jochen, 38600 Fontaine (FR)
(74) Vertreter: Rückert, Friedrich, Dr.

(56) Entgegenhaltungen:
- SENDA M ET AL: "MAGNETIC PROPERTIES OF FE/CO, FE/COFE, AND (FE/CO)/SIO2 MULTILAYER FILMS" JOURNAL OF APPLIED PHYSICS, Bd. 65, Nr. 8, 15.April 1989, Seiten 3151-3156, XP000054668

## Beschreibung

Die Erfindung betrifft eine magnetostriktive Viellagenschicht gemäß dem ersten Patentanspruch.

Es sind bereits eine Reihe von magnetostriktiven Viellagenschichten bekannt geworden.

Die GB 2 268 191 A beschreibt eine magnetostriktive Viellagenschicht mit einer periodischen Abfolge von mindestens zwei verschiedenen, nicht homogenen Lagen, wobei eine dieser Lagen magnetisch ist, die andere jedoch nicht. Als Beispiel für die magnetische Lage wird eine Eisen/Kobalt-Legierung genannt, während die nichtmagnetische Lage aus Silber bestehen kann. Die Anzahl der Lagen liegt ungefähr bei 20 bis 50 und die Lagendicken im Bereich weniger Nanometer. Die magnetostriktive Eigenschaft ergibt sich aus der gegenseitigen strukturellen Beeinflussung der übereinanderliegenden Lagen. Der Maximalwert der Magnetostriktion ist bei dieser Viellagenschicht jedoch verhältnismäßig niedrig.

Die aus der GB 2 268 191 A bekannte Viellagenschicht wird auch in der Veröffentlichung von M. R. J. Gibbs: "Piezomagnetic materials for use in microelectromechanical systems", Invited paper presented at the IoP Sensors & their Applications Conference Dublin, September 1995 erwähnt, die im übrigen die Grundlagen des Piezomagnetismus beschreibt.

Ähnlich aufgebaute magnetostriktive Viellagenschichten sind Gegenstand der Veröffentlichung von Y. K. Kim und S. C. Sanders: "Magnetostriction and giant magnetoresistance in annealed NiFe/Ag multilayers", Appl. Phys. Lett. **66** (8) (1995) 1009-1011.

Aus der Veröffentlichung von S. Honda, M. Ohtsu und T. Kusuda: "Spin-glass-like nature in Fe/DyFe multilayers", J. Appl. Phys. **70**(10) (1991) 6209-6211 ist eine weitere Viellagenschicht bekannt. Diese Viellagenschicht besteht aus einer alternierenden Abfolge von Fe- und DyFe-Lagen. Der Dy-Gehalt der amorphen DyFe-Lagen beträgt 62 at-%; die Lagen sind bei Normaltemperatur nicht magnetisch. Die Veröffentlichung gibt jedoch keinen Hinweis auf magnetostriktive Eigenschaften solcher oder ähnlicher Viellagenschichten.

Aus der Veröffentlichung von D. J. Sellmyer, J. A. Woolam, Z. S. Shan und W. A. McGahan: "Magnetic and Magneto-Optical Properties of Nanostructured Rare Earth-Transition Metall Multilayered Films", Mat. Res. Soc. Symp. Proc. Vol. 150 (1989) 51-61 sind Viellagenschichten bekannt, bei denen Lagen aus einem Seltenerd-Metall, z. B. Nd, Gd, Tb, Dy und Er, mit Lagen eines Übergangsmetalls wie z. B. Fe, Co und Ni abwechseln. Ein Hinweis auf magnetostriktive Eigenschaften solcher Viellagensysteme findet sich in der Veröffentlichung nicht.

Aufgabe der Erfindung ist, magnetostriktive Viellagenschichten vorzuschlagen, mit deren Hilfe sich höhere Magnetostriktionswerte erzielen lassen. Außerdem soll das Verhältnis von Sättigungsmagnetostriktion zu Sättigungsfeldstärke vergrößert werden.

Die Aufgabe wird durch die magnetostriktive Viellagenschicht gemäß Anspruch 1 gelöst. Die weiteren Ansprüche geben bevorzugte Ausgestaltungen der Viellagenschicht an.

Die Wirkung der erfindungsgemäßen magnetostriktiven Viellagenschichten ergibt sich nicht, wie bei den eingangs genannten magnetostriktiven Viellagenschichten, durch eine gegenseitige Beeinflussung der Kristallstruktur benachbarter Lagen, sondern aus der abwechselnden Anordnung zweier Lagen mit verschiedenen magnetischen Eigenschaften, die durch magnetische Austauschwechselwirkung gekoppelt sind.

Erfindungsgemäß wird als eine der beiden Lagen eine bei Raumtemperatur hochmagnetostriktive Schicht eingesetzt. Die Sättigungsmagnetostriktion dieser Lage muß mindestens 200•10⁻⁶ betragen. Die hochmagnetostriktive Lage besteht aus einer Legierung, die ein oder mehrere Seltenerdmetalle und Eisen und/oder Kobalt enthält. Beispiele für solche Lagen sind TbFe, TbDyFe, TbFeCo, TbCo, TbDyFeCo oder SmFe.

Zusätzlich können gegebenenfalls zwischen den einzelnen Lagen Haft- oder Diffusionssperrschichten o. ä. vorhanden sein, sofern diese Schichten so dünn sind, daß die magnetische Kopplung der hochmagnetostiktiven und der weichmagnetischen Lage nicht gestört wird.

Die zweite Lage ist weichmagnetisch und hoch magnetisierbar. Der Sättigungsmagnetisierung µ^{^{··}}H_{S} soll mehr als 1 Tesla und die Koerzitivfeldstärke H_{C} weniger als 5•10³ A/m betragen. Die Lage kann aus Fe, Co, Ni, FeCo, FeNi oder CoCr bestehen.

Bei Lagendicken unterhalb von 40 nm für die weichmagnetische Lage und unterhalb von 20 nm für die hochmagnetostriktive Lage können sich keine Blochwände an den Grenzflächen ausbilden, sondern die Magnetisierung der Viellagenschicht stellt sich als Durchschnittswert der einzelnen Lagen der Viellagenschicht dar. Insbesondere kann die Sättigungsfeldstärke einer solchen Viellagenschicht bei hohen Werten für die Magnetostriktion beträchtlich reduziert werden. Zur Erläuterung dieses Effekts soll eine Viellagenschicht mit gleich dicken Lagen betrachtet werden: Die weichmagnetische Lage habe eine Magnetisierbarkeit M_{S}^{himag}, keine Magnetostriktion und einen Anisotropiekoeffizienten K^{himag} ≈ 0, während die hochmagnetostriktive Lage eine Magnetisierung M_{S}^{MS}, eine Magnetostriktion λ und einen Anisotropiekoeffizienten K^{MS} aufweise. Typischerweise ist M_{S}^{himag} ≈ 5 M_{S}^{MS}, woraus sich eine Magnetisierung der Viellagenschicht von ≈ 3 M_{S}^{MS} ergibt. Der Anisotropiekoeffizient der Viellagenschicht ist K^{MS}/2 und damit die Sättigungsfeldstärke der Viellagenschicht K^{MS}/3 M_{S}^{MS} , H_{S}^{MS}/6. Selbst wenn die weichmagnetische Schicht keine Magnetostriktion zeigt, ist die Magnetostriktion der Viellagenschicht λ/2. Somit ist λ/H_{S} für für die Viellagenschicht 3 mal größer als für eine homogene magnetostriktive Einzellage.

Bei der erfindungsgemäßen Viellagenschicht die ist Magnetostriktion größer als bei einer einfachen Durchschnittsbildung über die magnetischen Eigenschaften der Einzellagen erwartet würde. Hierzu tragen insbesondere die großen Grenzflächen-Anisotropien bei, die sich bei Schichtdicken im Bereich von 1 bis maximal 40 nm (weichmagnetische Lage) bzw. 1 bis maximal 20 nm (hochmagnetostriktive Lage) ergeben. Die Anisotropien verstärken die Magnetostriktion an den Grenzflächen und damit in gesamten Viellagenschicht. Zusätzlich dringt in den Viellagenschichten das molekulare Feld der weichmagnetischen Lage in die hochmagnetostriktive Lage ein. Dies ist insbesondere für solche magnetostriktiven Materialien von Bedeutung, deren Curie-Punkt der Raumtemperatur nahekommt, z. B. Legierungen aus TbFe. In diesem Fall kann wegen des zusätzlichen molekularen Felds eine signifikante Verbesserung der magnetischen Eigenschaften der hochmagnetostriktiven Lage erwartet werden. Für Materialien, deren Curie-Punkt deutlich über der Raumtemperatur liegt, ist dieser Effekt wesentlich geringer ausgeprägt. Beide Effekte verstärken die Magnetostriktion der Viellagenschicht gegenüber dem Durchschnittswert für die einzelnen Lagen.

Wegen ihrer hohen Magnetostriktion bei kleinen Sättigungsfeldstärken µH, z. B. µH < 50 mT, eignet sich die erfindungsgemäße Viellagenschicht insbesondere zur Herstellung von Aktoren in der Mikrosystemtechnik. Die Viellagenschicht kann als magnetostriktive Aktorschicht angeordnet werden, die entweder durch integrierte Mikrospulen als auch ferngesteuert durch kleine magnetische Wechselfelder angesteuert werden können. Vor allem die Fernsteuerbarkeit ermöglicht neuartige Aktorkonzepte, bei denen eine direkte Energieversorgung des Aktors nicht möglich ist.

Mit einer Viellagenschicht vom Typ [Fe_{0,75}Co_{0,25}/Tb₁₋ₓCoₓ]ₙ wurde eine Koerzitivfeldstärke von 2-3 mT und ein höchster reversibler Wert von δb/δH (b ist der magnetoelastische Kopplungskoeffizient) von 920 MPa/T (d. h. δλ/δH = 18•10⁻³ T⁻¹) erreicht, wobei mit einem dynamischen Feldbereich von ± 2 mT um die Feldstärke 0 gemessen wurde. Ein höherer Abfall von 2500 MPa/T (d. h. δλ/δH = 50•10⁻³ T⁻¹) wurde mit einer nach dem Koerzitivfeld umgekehrten Magnetisierung gemessen. Der magnetoelastische Kopplungskoeffizient beträgt b//=15 MPa (d. h. λ// ≈ 300 ppm) und b⊥ = 10,8 MPa (λ⊥ = 215 ppm). Bei µₒH = 0,02 T wurde b//-b⊥ = 20,7 MPa entsprechend λ//-λ⊥ = 415 ppm gefunden.

Die erfindungsgemäßen Viellagenschichten lassen sich durch Sputterprozesse herstellen. Vorzugsweise wird die hochmagnetostriktive Lage durch DC-Magnetronsputtern und die weichmagnetische Lage durch HF-Magnetronsputtern erzeugt. Die Abscheidung der ersten Lage erfolgt auf ein z. B. im Ultraschallbad mit Aceton gereinigtes Substrat, das nachfolgend durch ein HF-Plasma ca 10 min lang geätzt worden ist. Als Substrate eignen sich Silicium, Quarz, Glas oder Metalle.

Das Sputtern erfolgt vorzugsweise mit Argon als Sputtergas und einer Sputterleistung von ca. 150 W, wobei ein Druck von ca. 4^{^{··}}10⁻³ mbar eingestellt wird. Die Bias-Spannung kann beispielsweise für die hochmagnetostriktiven Lagen ca. 220 V und für die weichmagnetischen Lagen 0 V betragen. Der Abstand zwischen Target und Substrat beträgt vorzugsweise 50 mm.

Für die mehrlagige Beschichtung wird das Substrat auf einen Drehteller gestellt, der für einstellbare Zeiten unter den Targets positioniert wird. Um eine Querbeschichtung zu vermeiden, kann synchron mit dem Drehteller eine Lochblende bewegt werden, die zur Beschichtung nur das gewünschte Target freigibt.

Anstelle eines Targets läßt sich auch eine Strahlungsheizung zur in-situ-Glühung der Substrate verwenden. Die oberste Lage der Viellagenschicht sollte zum Schutz gegen Oxidation aus der weichmagnetischen Schicht oder aus einer zusätzlichen, speziellen Schutzschicht, z. B. Chrom, bestehen.

Die magnetostriktiven und weichmagnetischen Eigenschaften der Lagen können durch eine anschließende Glühung im Hochvakuum verbessert werden. Die Glühtemperatur kann 280° C und die Glühdauer 15 Minuten betragen. Die einzelnen Lagen, die beim Sputtern amorph abgeschieden werden, kristallisieren bei der Glühung nicht, sondern bleiben röntgenamorph.

Die Erfindung wird im folgenden anhand von Figuren und Ausführungsbeispielen näher erläutert.

Es zeigen:
Fig. 1 eine schematische Darstellung der magnetostriktiven Viellagenschicht;
Fig. 2 die Magnetostriktion einer FeCo/TbCo-Viellagenschicht im Vergleich zu einer entsprechenden Einlagenschicht;
Fig. 3 den Einfluß einer Glühung bei 150° C auf die Magnetostriktion am Beispiel einer FeCo/TbCo-Viellagenschicht;
Fig. 4 den Einfluß der Glühung bei verschiedenen Temperaturen auf die Magnetostriktion;
Fig. 5 einen Vergleich der Viellagenschicht gemäß Fig. 4 gegenüber einer entsprechenden TbFe-Einlagenschicht;
Fig. 6 die Polarisation der Viellagenschicht gemäß Fig. 4;
Fig. 7 die Fig. 6 entsprechenden Polarisationsverläufe der TbFe-Einlagenschicht;
Fig. 8 einen Vergleich der experimentellen Ergebnisse zu einem Rechenmodell für das System Tb_{0,4}Fe_{0,6}/Fe;
Fig. 9 eine SEM-Aufnahme eines flachen Sputterkraters in eine Viellagenschicht.

### Beispiel 1

Zur Herstellung einer Viellagenschicht wurde ein Si-Wafer im Ultraschallbad mit Aceton gereinigt. Das Substrat wird in einen Rezipienten gestellt, wonach bis auf < 10⁻⁶ mbar evakuiert wurde. Der Argon-Partialdruck wurde auf 4•10⁻³ eingestellt. Das Substrat wurde dann 10 min lang mit 500 W HF-geätzt. Nun wurde die erste weichmagnetische Lage auf das Substrat aufgebracht. Hierzu wurde ohne BIAS bei einer Leistung von 150 W Eisen in einer Dicke von 6,5 nm auf das Substrat aufgesputtert. Mit 220 V Bias und einer Leistung von 150 W wurde nun die hochmagnetostriktive Lage bestehend aus Tb_{0,4}Fe_{0,6} in einer Dicke von 4,5 nm abgeschieden. Insgesamt wurden 245 Lagen auf das Substrat aufgetragen. Die oberste Lage bestand aus einer weichmagnetischen Fe-Lage. Die Viellagenschicht wurde anschließend bei 275° C 15 min lang im Vakuum geglüht.

### Beispiel 2

Gemäß dem oben beschriebenen Verfahren wurden Viellagenschichten der Zusammensetzung 1. [Fe_{0,75}Co_{0,25}/Tb₁₋ₓCoₓ]ₙ und 2. [Fe/Tb_{0,4}Fe_{0,6}]ₙ mit verschiedenen Lagendicken, unterschiedlicher Lagenanzahl n und unterschiedlichen stöchiometrischen Parametern x auf einem Siliciumsubstrat hergestellt. In den Figuren werden neben der Magnetostriktion λ der magnetoelastische Kopplungskoeffizient b, die mit der Biegebalkenmeßmethode bestimmt wurden, und die magnetischen Eigenschaften Sättigungsmagnetisierung M_{S}, Sättigungsmagnetfeld H_{S} und Koerzitivfeld H_{C}.

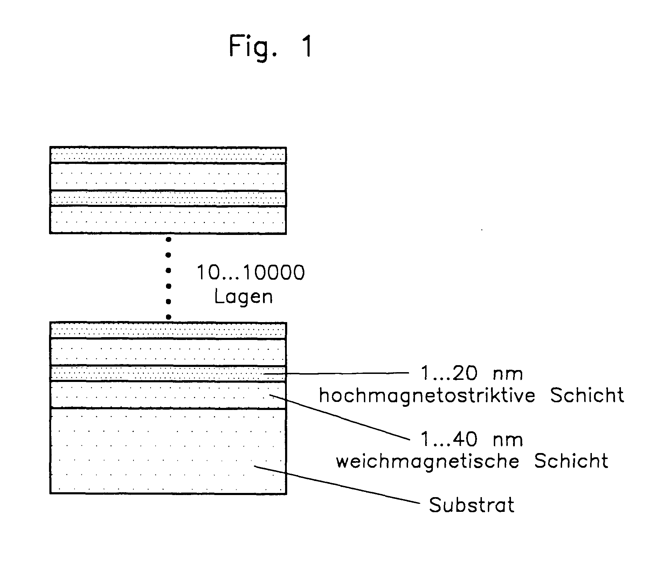

Fig. 1 zeigt eine schematische Darstellung der Viellagenschicht.

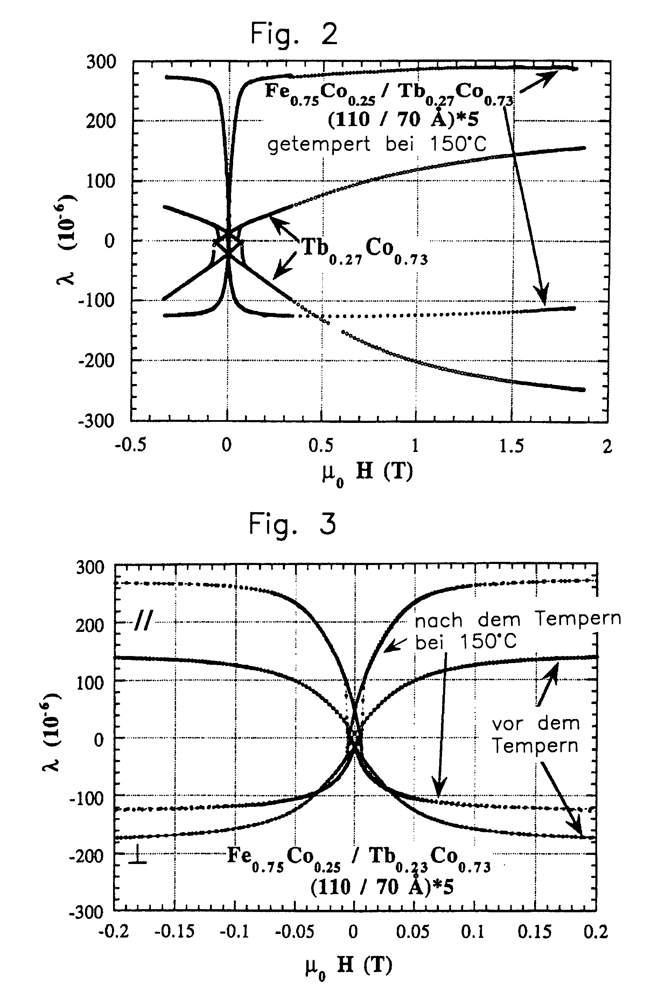

In Fig. 2 ist die Magnetostriktion in Abhängigkeit vom Magnetfeld (senkrecht oder parallel zur Meßrichtung) der Viellagenschicht [Fe_{0,75}Co_{0,25}^{(11 nm)}/Tb_{0,27}Co_{0,73}^{(7 nm)}]ₙ im Vergleich mit der Einzellagenschicht Tb_{0,27}Co_{0,73}. Es zeigt sich zum einen die hohen erzielbaren Magnetostriktionen (> 250·10⁻⁶) sowie die deutliche Reduktion der Sättigungsfeldstärke (für H(^{⊥}) von ca. 2 T auf ca. 0,1 T).

Fig. 3 zeigt den Einfluß einer Temperung bei 150° C auf den Anstieg der Magnetostriktion und die leichte Reduktion der Sättigungsfeldstärke am Beispiel einer Fe_{0,75}Co_{0,25}(11 ^{nm)}/TbCo_{2,7} ^{(7 nm)})-Schicht.

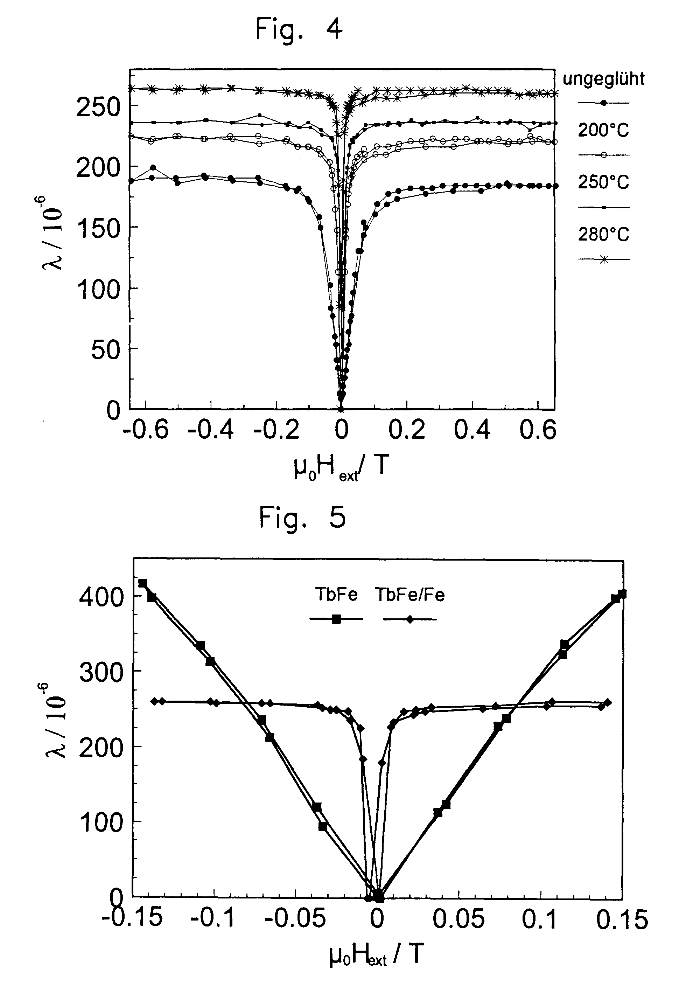

Fig. 4 zeigt den Einfluß der Glühtemperatur auf die Magnetostriktion (Magnetfeld parallel zur Meßrichtung) bei einer Viellagenschicht Tb_{0,4}Fe_{0,6}^{(4,5nm)}/Fe^{(6,5 nm)} und verdeutlicht, daß in diesem System Magnetostriktionen > 250·10⁻⁶ erreicht werden können.

Fig. 5 zeigt den Vergleich der Viellagenschicht gemäß Fig. 4 zu einer entsprechenden TbFe-Einlagenschicht und verdeutlicht, daß in diesen Systemen eine Sättigungsfeldstärke von 20 mT erreicht werden kann.

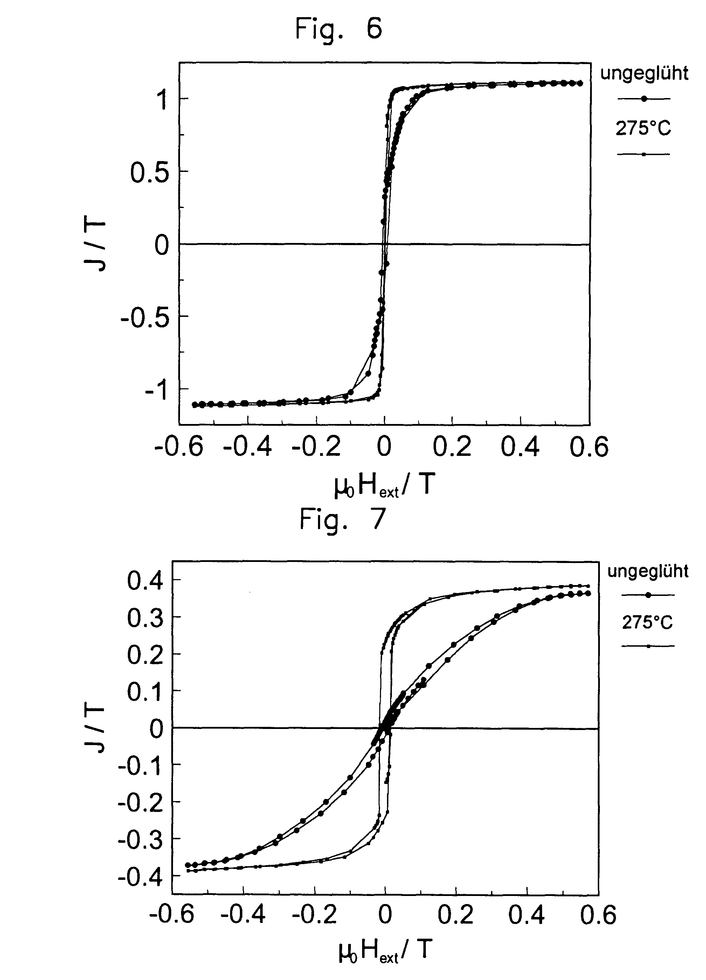

Fig. 6 zeigt die Polarisation der Viellagenschicht gemäß Fig. 4 und verdeutlicht den Einfluß der Glühung auf die Reduktion der Sättigungsfeldstärke.

Fig. 7 zeigt die entsprechenden Polarisationsverläufe der TbFe-Einzellagenschicht mit der deutlich geringeren Sättigungspolarisation.

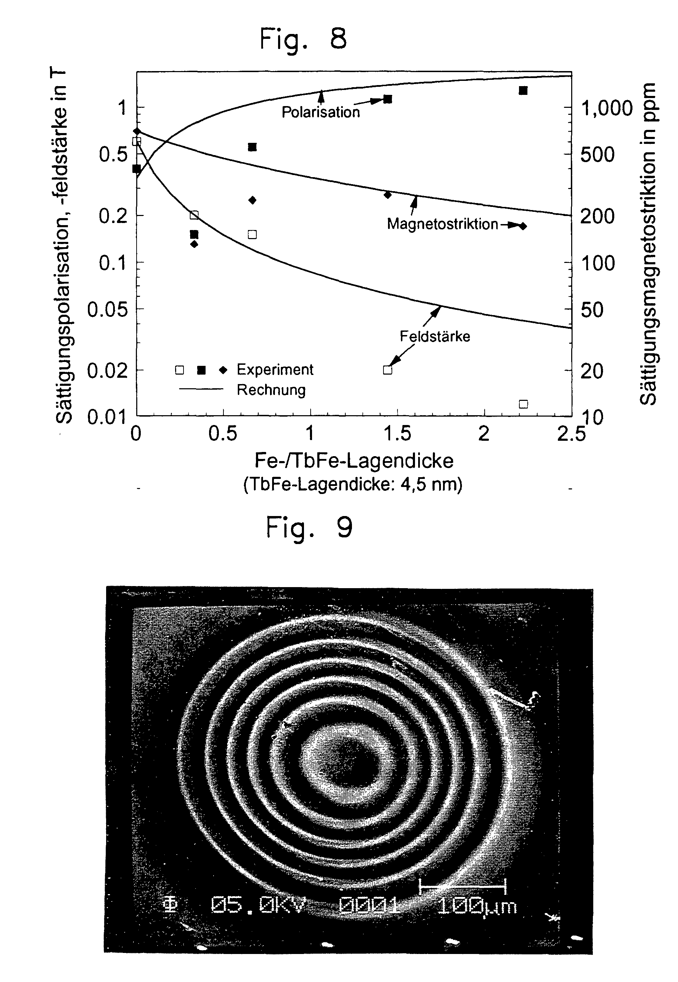

In Fig. 8 ist der Vergleich experimenteller Ergebnisse zu einem Rechenmodell für die Viellagenschicht Tb_{0,4}Fe_{0,6}/Fe dargestellt.

Schließlich ist in Fig. 9 eine SEM-Aufnahme eines flachen Sputterkraters in eine Viellagenschicht dargestellt. Es sind terrassenförmig die unterschiedlichen Lagen der Viellagenschicht zu erkennen.

## Patentansprüche

1. Magnetostriktive Viellagenschicht mit einer alternierenden Abfolge einer bei Raumtemperatur hochmagnetostriktiven und einer weichmagnetischen Lage, wobei
- die hochmagnetostriktive Lage eine Sättigungsmagnetostriktion von mehr als 200•10⁻⁶ aufweist, aus einer Legierung besteht, die mindestens ein Seltenerdmetall sowie Eisen und/oder Kobalt enthält und zwischen 1 und 20 nm dick ist,
- die zweite Lage weichmagnetisch mit einem Sättigungsmagnetisierung µ•H_{S} von mehr als 1 Tesla und einer Koerzitivfeldstärke H_{C} von weniger als 5•10³ Ampère/Meter ist sowie zwischen 1 und 40 nm dick ist.

2. Magnetostriktive Viellagenschicht nach Anspruch 1, bei der die Gesamtzahl der Lagen 10 bis 10000 beträgt.

3. Magnetostriktive Viellagenschicht nach Anspruch 1 oder 2, bei der die hochmagnetostriktive und die weichmagnetische Lage amorph sind.

## Claims

1. Magnetostrictive multi-ply layer, having an alternating sequence of a ply which is highly magnetostrictive at ambient temperature and a soft-magnetic ply, wherein
- the highly magnetostrictive ply has a saturation magnetostriction of more than 200•10⁻⁶ and is formed from an alloy which contains at least one rare earth metal as well as iron and/or cobalt and has a thickness of between 1 and 20 nm; and
- the second ply is soft-magnetic with a saturation magnetisation µ•Hₛ of more than 1 Tesla and a coercitive field strength H_{c} of less than 5•10³ ampere/metre, as well as having a thickness of between 1 and 40 nm.

2. Magnetostrictive multi-ply layer according to claim 1, wherein the total number of plies is between 10 and 10000.

3. Magnetostrictive multi-ply layer according to claim 1 or 2, wherein the highly magneteostrictive ply and the soft-magnetic ply are amorphous.

## Revendications

1. Multicouche magnétostrictive composée d'une alternance d'une couche fortement magnétostrictive à température ambiante et d'une couche magnétique douce,
multicouche dans laquelle
- la couche fortement magnétostrictive a une magnétostriction de saturation de plus de 200•10⁻⁶ et elle est formée d'un alliage comprenant au moins un métal de terres rares et du fer et/ou du cobalt et son épaisseur est comprise entre 1 et 20 nm,
- la seconde couche à magnétisme doux a une aimantation de saturation µ•H_{S} supérieure à 1 Tesla et une intensité de champ coercitif H_{C} inférieure à 5•10³ A/m et son épaisseur est comprise entre 1 et 40 nm.

2. Multicouche magnétostrictive selon la revendication 1,
**caractérisée en ce que**
le nombre total des couches est compris entre 10 et 10 000.

3. Multicouche magnétostrictive selon la revendication 1 ou la revendication 2,
**caractérisée en ce que**
la couche très magnétostrictive et la couche à aimantation douce sont amorphes.
